# EUROPÄISCHE PATENTSCHRIFT

(11) **EP 2 622 332 B1**
(45) Veröffentlichungstag und Bekanntmachung des Hinweises auf die Patenterteilung: **06.08.2014**
(21) Anmeldenummer: 11778539.4
(22) Anmeldetag: 28.09.2011
(51) Int. Cl.: G01N 25/72, G01R 31/26, G01R 31/265

(54) **VERFAHREN ZUR ANALYSE PHOTOVOLTAISCHER SCHICHTENSYSTEME MITTELS THERMOGRAPHIE**
METHOD OF ANALYSING PHOTOVOLTAIC LAYER SYSTEMS USING THERMOGRAPHY
PROCÉDÉ D'ANALYSE DE SYSTÈMES DE COUCHES PHOTOVOLTAÏQUES PAR THERMOGRAPHIE

(30) Priorität: 28.09.2010 EP 10180708
(43) Veröffentlichungstag der Anmeldung: 07.08.2013
(73) Patentinhaber: Saint-Gobain Glass France, 92400 Courbevoie (FR)
(72) Erfinder: DALIBOR, Thomas, 82211 Herrsching am Ammersee (DE)
(74) Vertreter: Gebauer, Dieter Edmund
(86) Internationale Anmeldenummer: PCT/EP2011/066898
(87) Internationale Veröffentlichungsnummer: WO 2012/052269

(56) Entgegenhaltungen:
- WO-A1-2011/016420
- US-A1- 2010 182 421
- US-A1- 2010 201 374

## Beschreibung

Die Erfindung liegt auf dem technischen Gebiet der Herstellung von Einrichtungen zur photovoltaischen Energieerzeugung und betrifft ein Verfahren zur bewertenden, quantitativen Analyse photovoltaischer Schichtensysteme.

Solarzellen ermöglichen eine direkte Umwandlung von Lichtstrahlung in elektrischen Strom. Hinsichtlich des Wirkungsgrads haben sich Dünnschichtsolarzellen auf Basis polykristalliner Chalkopyrit-Halbleiter als vorteilhaft erwiesen. Hier zeichnet sich insbesondere Kupfer-Indium-Diselenid (CuInSe₂ bzw. CIS) aufgrund seines an das Spektrum des Sonnenlichts angepassten Bandabstands durch einen besonders hohen Absorptionskoeffizienten aus. Dünnschichtsolarzellen benötigen für eine ausreichende mechanische Festigkeit spezielle Trägersubstrate, die meist anorganisches Glas, Polymere oder Metall-legierungen enthalten und in Abhängigkeit von der Schichtdicke und Materialeigenschaften als starre Platten oder biegsame Folien ausgestaltet sein können. Da mit einzelnen Solarzellen typischer Weise nur Spannungspegel von weniger als 1 Volt erreichbar sind, werden in der Regel viele Solarzellen in einem Solarmodul seriell verschaltet, um auf diese Weise eine technisch brauchbare Ausgangsspannung zu erhalten. Dabei bieten Dünnschichtsolarmodule den besonderen Vorteil, dass die Solarzellen schon während der Schichtenherstellung in integrierter Form seriell verschaltet werden können. Um einen dauerhaften Schutz vor Umwelteinflüssen sicherzustellen, werden die Solarzellen üblicherweise mit eisenarmen Natron-Kalk-Gläsern und haftvermittelnden Polymerfolien zu einem bewitterungsstabilen Verbund kombiniert.

Nun können bei der Herstellung von Solarmodulen verschiedenartige Defekte auftreten, welche in nachteiliger Weise interne elektrische Leistungsverluste bewirken und somit den Wirkungsgrad von Solarmodulen vermindern. Wesentliche Ursache für solche Leistungsverluste sind beispielsweise Kurzschlüsse (Shunts), die zu einer lokal erhöhten Rekombinationsrate von Ladungsträgern führen, und relativ hohe Serienwiderstände, die sich im Wesentlichen aus den ohmschen Widerständen von Metallkontakten, Zuleitungen und Halbleitermaterial sowie Kontaktwiderständen von Metall-Halbleiterkontakten ergeben. Weiterhin können beispielsweise mechanische Defekte wie Risse, Brüche und Delaminierungen oder Variationen der Materialqualität zu Leistungsverlusten führen.

In der Serienfertigung von Solarmodulen ist es im Rahmen einer zufrieden stellenden Qualitätskontrolle, insbesondere zur Erfüllung bestimmter Qualitätsvorgaben, wichtig, Solarmodule mit hohen internen Leistungsverlusten erkennen zu können. Bekannt ist es, zu diesem Zweck spezielle Infrarotmesstechniken einzusetzen, bei denen ein elektrischer Strom im Solarmodul erzeugt und mittels einer Infrarot-Kamera ein Wärmebild der Oberfläche des Solarmoduls aufgenommen wird. Da alle elementaren Prozesse in den Solarzellen stets mit einer Wärmedissipation verbunden sind und Defekte, wie Kurzschlüsse und Serienwiderstände, typischer Weise mit einer relativ hohen Verlustleistung behaftet sind, können diese durch eine lokal erhöhte Temperatur der Oberfläche des Solarmoduls erkannt werden. Im Wärmebild erscheinen die Defekte beispielsweise als hellere (wärmere) Stellen ("hot spots") oder Bereiche. In der wissenschaftlichen Literatur wurde diese Vorgehensweise in einer Mehrzahl von Druckschriften bereits eingehend beschrieben. Lediglich beispielhaft sei diesbezüglich auf den Fachartikel mit dem Titel "Quantitative Evaluation of Shunts in Solar Cells by Lock-in Thermography" von O. Breitenstein et al. in "Progress in Photovoltaics: Research and Applications" (Prog. Photovolt: Res. Appl. 2003; 11:515-526) und die darin genannten Zitatstellen verwiesen.

Weiterer technischer Hintergrund kann der Patentanmeldung US 2010/182421 A1 entnommen werden.

In der Serienfertigung von Solarmodulen werden die Wärmebilder in der Regel visuell begutachtet, wobei anhand der Anzahl hellerer Stellen eine qualitative, in wesentlicher Weise auf Erfahrungen des Begutachtenden basierende Aussage über deren Güte getroffen wird.

Die US-Patentanmeldung US 2010/201374 A1 beschreibt ein Verfahren zur Analyse eines photovoltaischen Schichtensystems, bei dem ein ortsaufgelöstes Bild der Wärmestrahlung einer Oberfläche des Schichtensystems ausgewertet wird.

Demgegenüber besteht die Aufgabe der vorliegenden Erfindung darin, eine quantitative Analyse der Solarmodule zur Verfügung zu stellen, die eine automatisierte Bewertung der Güte von Solarmodulen ermöglicht. Diese und weitere Aufgaben werden nach dem Vorschlag der Erfindung durch ein Verfahren mit den Merkmalen des unabhängigen Patentanspruchs gelöst. Vorteilhafte Ausgestaltungen der Erfindung sind durch die Merkmale der Unteransprüche angegeben.

Erfindungsgemäß ist ein Verfahren zur bewertenden, quantitativen Analyse eines Schichtensystems zur photovoltaischen Energieerzeugung gezeigt. Im Schichtensystem findet eine Trennung der erzeugten Ladungsträger oder Exzitonen statt, beispielsweise über interne elektrische Felder. Das Schichtensystem umfasst vorzugsweise zumindest eine, einen Hetero- bzw. pn-Übergang, das heißt eine Abfolge von Bereichen mit unterschiedlichem Leitungstyp, bildende Halbleiterschicht.

Bei dem photovoltaischen Schichtensystem kann es sich beispielsweise um eine (Einzel-)Solarzelle, mehrere in Reihe oder als Array verschaltete Solarzellen oder um ein, eine Vielzahl seriell verschalteter Solarzellen enthaltendes Solarmodul handeln. Insbesondere kann es sich bei dem Solarmodul um ein Dünnschichtsolarmodul handeln, in dem die Solarzellen beispielsweise in integrierter Form seriell verschaltet sind. Ein solches Dünnschichtsolarmodul umfasst typischer Weise zumindest ein Trägersubstrat, sowie eine erste Elektrodenschicht, eine zweite Elektrodenschicht und zumindest eine zwischen den beiden Elektrodenschichten angeordnete Halbleiterschicht. Üblicher Weise ist die Halbleiterschicht mit einem Dotierstoff dotiert. Alternativ kann die Halbleiterschicht mit einem Stoff, beispielsweise Natrium, dotiert werden, der zu einer intrinsischen Dotierung durch Eigendefektbildung führt. Vorzugsweise besteht die Halbleiterschicht aus einer Chalkopyritverbindung, bei der es sich insbesondere um einen I-III-VI-Halbleiter aus der Gruppe Kupfer-Indium/Gallium-Dischwefel/Diselenid (Cu(InGa)(SSe)₂), beispielsweise Kupfer-Indium-Diselenid (CuInSe₂ bzw. CIS), Natrium-dotiertes Cu(InGa)(SSe)₂ oder verwandte Verbindungen, handeln kann.

Bei dem photovoltaischen Schichtensystem kann es sich aber auch um ein Zwischenprodukt bei der Herstellung von Solarzellen bzw. Solarmodulen handeln, das zumindest eine, einen pn-Übergang bildende, Halbleiterschicht umfasst.

In dem erfindungsgemäßen Verfahren zur bewertenden, quantitativen Analyse des photovoltaischen Schichtensystems wird ein elektrischer Strom im Schichtensystem erzeugt, durch den eine elektrische Verlustleistung unter anderem im Bereich von Defekten des Schichtensystems bewirkt wird, so dass die Defekte durch eine gegenüber der umgebenden Temperatur erhöhte Temperatur einer Oberfläche des Schichtensystems erkennbar sind. Der elektrische Strom kann durch Anlegen einer elektrischen Spannung in Sperr- und/oder Flussrichtung des pn-Übergangs an das Schichtensystem erzeugt werden. Denkbar ist aber auch, dass der Strom im Schichtensystem berührungslos durch Bestrahlen mit Licht erzeugt wird, wobei auf diese Weise insbesondere Zwischenprodukte bei der Herstellung von Solarmodulen, die noch nicht über äußere elektrische Anschlüsse verfügen, in einfacher Weise einer bewertenden, quantitativen Analyse durch das erfindungsgemäße Verfahren unterzogen werden können.

In einer zum Erfassen der durch den Stromfluss erzeugten Leistungsverluste geeigneten zeitlichen Relation, insbesondere gleichzeitig mit oder zeitnah zur Stromerzeugung, wird mittels einer Wärmebild- bzw. Infrarotkamera ein ortsaufgelöstes Wärmebild der Wärmestrahlung einer Oberfläche des photovoltaischen Schichtensystems erzeugt. In Solarmodulen kann es sich dabei insbesondere um die für den Lichteinfall vorgesehene Oberfläche handeln. Typischer Weise basiert das die Wärmestrahlung erfassende Wärmebild auf einer Wärmeverteilung der Oberfläche des Schichtensystems. Vorteilhaft wird dabei die so genannte "Lock-in Technik" eingesetzt, bei der für die Stromerzeugung im Schichtensystem ein Modulationsverfahren verwendet wird. Da diese Vorgehensweise für das Verständnis der Erfindung nicht wesentlich und dem Fachmann wohlbekannt ist, erübrigt es sich hierauf näher einzugehen.

Das (digitale) Wärmebild ist als digitales Rasterbild aus einer Vielzahl Bildpunkte bzw. Bildzellen (Pixel) zusammengesetzt. In entsprechender Weise kann die Oberfläche des Schichtensystems zumindest gedanklich in eine Vielzahl Flächenelemente unterteilt werden, denen jeweils ein Bildpunkt des Wärmebilds eineindeutig zugeordnet ist. Andererseits ist jedem Bildpunkt als Bildpunktwert ein Intensitätswert entsprechend der Oberflächentemperatur des zugehörigen Flächenelements zugeordnet. Im Wärmebild weisen Bildpunkte (Pixel), die Stellen der Oberfläche mit unterschiedlicher Oberflächentemperatur entsprechen, einen voneinander verschiedenen Intensitätswert auf. Dabei erscheinen Bildpunkte, die wärmeren Stellen der Oberfläche entsprechen, beispielsweise heller und haben demzufolge einen höheren Intensitätswert, während Bildpunkte, die kälteren Stellen entsprechen, dunkler erscheinen und demzufolge einen niedrigeren Intensitätswert haben. In einer alternativen Skalierung kann eine wärmere Stelle der Oberfläche einem dunkleren Bildpunkt entsprechen und eine kältere Stelle dementsprechend einem helleren Bildpunkt. Alternativ kann das Wärmebild in Falschfarben dargestellt sein, wobei verschiedenen Farben verschiedene Intensitätswerte zugeordnet werden. Andererseits haben Bildpunkte (Pixel), die Stellen der Oberfläche mit einer selben Oberflächentemperatur entsprechen, einen gleichen Intensitätswert.

Anschließend wird auf Basis des Wärmebilds eine auf die jeweilige Anzahl von Bildpunkten mit einem selben Intensitätswert bezogene Intensitätsverteilung der Wärmestrahlung ermittelt. Anders ausgedrückt, wird für jeden Intensitätswert des Wärmebilds die Anzahl der Bildpunkte mit diesem Intensitätswert ermittelt. Aus der auf die Bildpunktzahl bezogenen Intensitätsverteilung wird daraufhin ein Intensitätsmittelwert oder alternativ Intensitätsmedian ermittelt.

Weiterhin wird ein auf der Intensitätsverteilung basierendes Intensitätsintervall auf Basis eines vorgebbaren Maßes für eine Streuung der Intensitätsverteilung ermittelt. Das vorgebbare Maß für die Streuung der Intensitätsverteilung basiert auf dem Intensitätsmittelwert/-median. Vorzugsweise wird als Maß für die Streuung der Intensitätsverteilung eine Standardabweichung oder ein Quantil, insbesondere Quartil, des Intensitätsmittelwerts/-medians der Intensitätsverteilung ermittelt und das Intensitätsintervall auf Basis der Standardabweichung bzw. des Quantils festgelegt. Beispielsweise entspricht das Intensitätsintervall dabei dem n-fachen der Standardabweichung oder des Quantils, insbesondere Quartils (n ist eine Dezimalzahl, insbesondere eine ganze Zahl größer als Null), beispielsweise dem Ein- oder Mehrfachen (z. B. Zwei- oder Dreifachen) der Standardabweichung oder des Quantils, insbesondere Quartils.

Anschließend wird eine Kennzahl durch Summieren von Produkten ermittelt, wobei die Produkte jeweils gegeben sind durch die Anzahl von Bildpunkten mit einem selben Intensitätswert multipliziert mit diesem Intensitätswert. Wesentlich hierbei ist, dass die Produkte nur für jene Intensitätswerte summiert werden, die größer als der um das Intensitätsintervall erhöhte Intensitätsmittelwert bzw. Intensitätsmedian sind.

Dann wird die so ermittelte Kennzahl oder alternativ ein hierauf basierender Berechnungswert mit einer vorgebbaren Referenzkennzahl verglichen, wobei dem Schichtensystem ein erstes Bewertungsergebnis zugewiesen wird, falls die Kennzahl größer oder gleich der Referenzkennzahl ist, oder ein vom ersten Bewertungsergebnis verschiedenes, zweites Bewertungsergebnis zugewiesen wird, falls die Kennzahl kleiner als die Referenzkennzahl ist. Bei dem ersten Bewertungsergebnis kann es sich beispielsweise um die Aussage "Schichtensystem erfüllt die geforderte Güte nicht", bei dem zweiten Bewertungsergebnis beispielsweise um die Aussage "Schichtensystem erfüllt die geforderte Güte" handeln.

Wie Versuche der Anmelderin gezeigt haben, können durch das erfindungsgemäße Verfahren photovoltaische Schichtensysteme wie Solarzellen und Solarmodule in einfacher Weise einer automatisierten quantitativen Analyse und Bewertung ihrer Güte unterzogen werden. Das Verfahren ermöglicht, dass Schichtensysteme mit unerwünscht hohen internen Leistungsverlusten auf Grund von Defekten zuverlässig und sicher erkannt werden, so dass die Einhaltung von Qualitäts- und Güteanforderungen gewährleistet werden kann.

Wie bereits ausgeführt wurde, kann in dem erfindungsgemäßen Verfahren der eine Verlustleistung bewirkende Strom durch Anlegen einer Spannung in Sperr- und/oder Stromflussrichtung des pn-Übergangs erzeugt werden. Falls eine Spannung in Sperrrichtung angelegt wird, entsteht die elektrische Verlustleistung in wesentlicher Weise durch den ohmschen Widerstand der Halbleiterschicht, wobei sich Strukturierungslinien, die in einem Solarmodul für eine elektrische Serienverschaltung der Solarzellen ausgebildet sind, dabei besonders stark erwärmen. Andererseits werden durch eine in Flussrichtung angelegte Spannung überwiegend die Verlustleistungen im Zellenbereich erkennbar. In vorteilhafter Weise werden in dem erfindungsgemäßen Verfahren Spannungen mit verschiedener Polarität und/oder verschiedenen Spannungswerten angelegt, um hierdurch insbesondere verschiedenartige Defekte im Schichtensystem unterscheidbar zu machen.

Bei einer weiteren vorteilhaften Ausgestaltung des erfindungsgemäßen Verfahrens wird die ermittelte Kennzahl normiert, indem sie beispielsweise durch eine Gesamt-Kennzahl geteilt wird. Die Gesamt-Kennzahl wird berechnet, indem Produkte, gegeben durch die jeweilige Anzahl von Bildpunkten mit einem selben Intensitätswert multipliziert mit dem Intensitätswert, für alle Intensitätswerte der Intensitätsverteilung summiert werden. In diesem Fall kann es weiterhin von Vorteil sein, wenn als ein auf der Kennzahl basierender Berechnungswert zum Vergleich mit der Referenz-Kennzahl ein Quotient zwischen der Kennzahl und der Gesamt-Kennzahl ermittelt wird. Alternativ kann es von Vorteil sein, wenn als ein auf der Kennzahl basierender Berechnungswert zum Vergleich mit der Referenz-Kennzahl eine Differenz zwischen der Kennzahl und der Gesamt-Kennzahl ermittelt wird.

Bei einer weiteren vorteilhaften Ausgestaltung des erfindungsgemäßen Verfahrens wird für eine Mehrzahl voneinander verschiedener Abschnitte der Oberfläche des Schichtensystems jeweils eine separate Kennzahl ermittelt. Die für die verschiedenen Oberflächenabschnitte des Schichtensystems ermittelten Kennzahlen ermöglichen eine abschnittsweise Bewertung der Güte des photovoltaischen Schichtensystems, wodurch insbesondere für den Fall, dass in bestimmten Abschnitten eine hohe Zahl von Defekten auftritt, durch die Information über die räumliche Lage schon während der Herstellung gezielt Maßnahmen zur Verbesserung der Güte des Schichtensystems getroffen werden können. Bei dieser Ausgestaltung des Schichtensystems kann es insbesondere von Vorteil sein, wenn die Abschnitte jeweils zumindest eine Strukturierungslinie zur Strukturierung des Schichtensystems enthalten, da Defekte häufig im Bereich der Strukturierungslinien auftreten.

Die Abschnitte können vorteilhaft auch danach gebildet werden, dass sie in Bereiche trennen, die nur die Strukturierungslinien enthalten und solche, die nur reine Zellenanteile enthalten.

Die Erfindung erstreckt sich weiterhin auf die Verwendung eines wie oben beschriebenen Verfahrens zur bewertenden Analyse von Solarmodulen, insbesondere Dünnschichtsolarmodulen, deren Halbleiterschicht aus einer Chalkopyritverbindung, insbesondere Cu(In,Ga)(S,Se)₂, besteht.

Die Erfindung wird nun anhand eines Ausführungsbeispiels näher erläutert, wobei Bezug auf die beigefügten Figuren genommen wird. Es zeigen in vereinfachter, nicht maßstäblicher Darstellung:
- Fig. 1: eine schematische Darstellung eines beispielhaften Aufbaus zur Durchführung des erfindungsgemäßen Verfahrens;
- Fig. 2A-2B: Wärmebilder eines Solarmoduls mit geringer Defektzahl (Fig. 2A) und hoher Defektzahl (Fig. 2B);
- Fig. 3: ein Diagramm zur Veranschaulichung der Intensitätsverteilungen der Wärmebilder von Fig. 2A-2B.

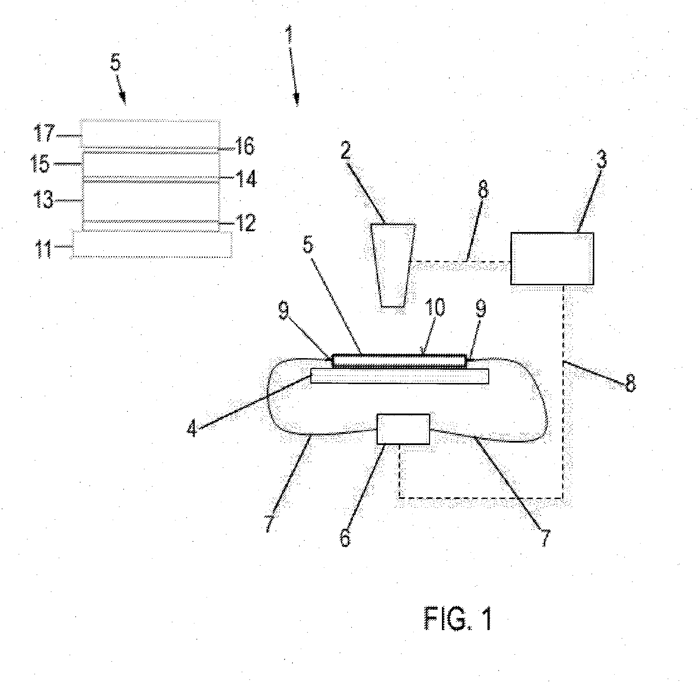

In Figur 1 ist in schematischer Weise ein beispielhafter Aufbau 1 zur Durchführung des erfindungsgemäßen Verfahrens veranschaulicht. Demnach umfasst der Aufbau 1 ein zu analysierendes Dünnschichtsolarmodul 5, welches in üblicher Weise über eine Mehrzahl in integrierter Form seriell verschaltete Solarzellen zur photovoltaischen Energieerzeugung verfügt, was in Figur 1 nicht näher dargestellt ist.

Wie der vergrößerten Darstellung des Dünnschichtsolarmoduls 5 von Fig. 1 zu entnehmen ist, kann jede Solarzelle des Dünnschichtsolarmoduls 1 beispielsweise folgendes Schichtensystem umfassen: Auf einem beispielsweise aus Glas mit einer relativ geringen Lichtdurchlässigkeit bestehenden, isolierenden ersten Substrat 11 ist eine beispielsweise aus einem lichtundurchlässigen Metall wie Molybdän (Mo) bestehende Rückelektrodenschicht 12 angeordnet. Auf der Rückelektrodenschicht 12 ist eine photovoltaisch aktive Absorberschicht 13 aus einem dotierten Halbleiter abgeschieden. Beispielsweise besteht die Absorberschicht 13 aus einem p-leitenden Chalkopyrit-halbleiter, insbesondere einer Verbindung der Gruppe Cu(InGa)(SSe)₂, beispielsweise Natrium (Na)-dotiertes Kupfer-Indium-Diselenid (CInSe₂). Auf die Absorberschicht 13 ist eine Pufferschicht 14 abgeschieden, die hier beispielsweise aus einer Einzellage Cadmiumsulfid (CdS) und einer Einzellage intrinsisches Zinkoxid (i-ZnO) besteht. Auf die Pufferschicht 14 ist eine transparente Frontelektrodenschicht 15 beispielsweise durch Aufdampfen aufgebracht, welche beispielsweise aus einem dotierten Metalloxid, beispielsweise n-leitendes, Aluminium (Al)-dotiertes Zinkoxid (ZnO) besteht. Hierdurch wird ein Heteroübergang, d.h. eine Abfolge von Schichten von unterschiedlichem Materialtyp und entgegen gesetztem Leitungstyp, gebildet. Zum Schutz vor Umwelteinflüssen ist auf der Frontelektrodenschicht 15 eine beispielsweise aus Polyvinylbutyral (PVB) und/oder Ethylenvinylacetat (EVA) bestehende Klebschicht 16 aufgebracht. Zudem ist ein für Sonnenlicht transparentes zweites Substrat 17 vorgesehen, das beispielsweise aus extraweißem Glas mit geringem Eisengehalt besteht. Das zweite Substrat 17 ist mit dem ersten Substrat 11 durch die Klebschicht 16 verbunden und dient zur Versiegelung des Schichtensystems.

Das Dünnschichtsolarmodul 1 kann in der industriellen Serienfertigung einfach und kostengünstig hergestellt werden, wobei die verschiedenen Schichten auf dem ersten Substrat 11 abgeschieden und unter Einsatz einer geeigneten Strukturierungstechnologie wie Laserschreiben und mechanische Bearbeitung beispielsweise durch Abheben oder Ritzen, zur Herstellung der seriell verschalteten Solarzellen strukturiert werden. Eine solche Strukturierung umfasst für jede Solarzelle typischer Weise drei Strukturierungsschritte zur Herstellung von drei Strukturierungslinien, die in der vergrößerten Darstellung des Dünnschichtsolarmoduls von Fig. 1 nicht gezeigt sind.

Wie in Fig. 1 erkennbar, ist das Dünnschichtsolarmodul 5 mit seiner Unterseite auf einem flächigen Träger 4 gelagert, so dass eine lichteintrittseitige Oberseite bzw. Oberfläche 10 des Dünnschichtsolarmoduls 5 frei liegt. An zwei einander gegenüberliegend angeordneten, äußeren Anschlüssen 9, welche mit den Front- bzw. Rückelektrodenschichten 12, 15 der Solarzellen verbunden sind, ist das Dünnschichtsolarmodul 1 über erste elektrische Leitungen 7 mit einer regelbaren Spannungsquelle 6 verbunden. Oberhalb der lichteintrittsseitigen Oberfläche 10 des Dünnschichtsolarmoduls ist eine Infrarotkamera 2 in Stellung gebracht, durch welche die Wärmestrahlung der Oberfläche 10 in einem Wärmebild ortsaufgelöst erfasst werden kann. In der Regel entspricht die Wärmestrahlung einer Temperaturverteilung der Oberfläche 10 des Dünnschichtsolarmoduls 1. Nicht dargestellt sind abbildende optische Elemente des Aufbaus 1. Sowohl die Infrarotkamera 2 als auch die Spannungsquelle 6 sind über zweite elektrische Leitungen 8 (Datenleitungen) mit einer prozessorbasierten Steuer-/Kontrolleinrichtung 3 datentechnisch verbunden.

Gesteuert durch die Steuer-/Kontrolleinrichtung 3 wird für eine quantitative Analyse des Dünnschichtsolarmoduls 5 zunächst über die Spannungsquelle 6 eine elektrische Spannung an die beiden äußeren Anschlüsse 9 des Dünnschichtsolarmoduls 5 angelegt. Hierdurch wird ein elektrischer Strom im Dünnschichtsolarmodul 5 erzeugt, durch den elektrische Verlustleistungen insbesondere im Bereich der Defekte des Dünnschichtsolarmoduls 1 induziert wird, die als lokale Temperaturerhöhung an den Stellen der Defekte an der Oberfläche 10 des Dünnschichtsolarmoduls 5 erkennbar sind. Die angelegte Spannung unterliegt einer bestimmten Modulation, worauf hier nicht näher eingegangen wird. Gleichzeitig bzw. in einer geeigneten zeitlichen Relation zur Stromerzeugung wird mittels der Infrarotkamera 2 ein ortsaufgelöstes Wärmebild der Wärmestrahlung der Oberfläche 10 des Dünnschichtsolarmoduls 5 erzeugt.

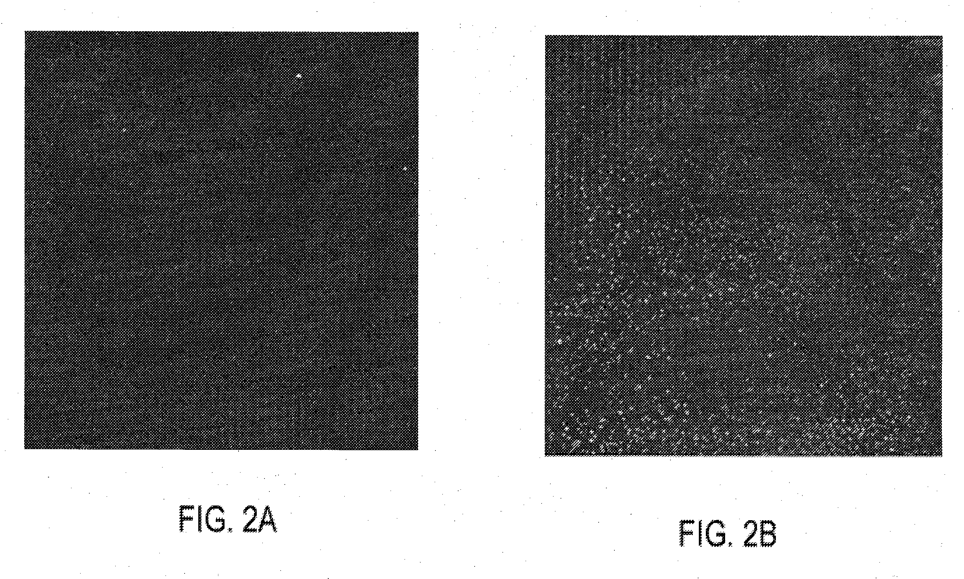

In Fig. 2A und 2B sind beispielhaft zwei verschiedene Wärmebilder für den Fall eines Dünnschichtsolarmoduls 5 mit einer geringeren Defektzahl (Fig. 2A) und mit einer größeren Defektzahl (Fig. 2B) gezeigt. In den Wärmebildern sind die Defekte gegenüber der kälteren Umgebung jeweils als helle Stellen erkennbar. Die den Defekten entsprechenden Bildpunkte (Pixel) weisen somit einen höheren Intensitätswert auf als Bildpunkte, die der kühleren Defektumgebung entsprechen. In den beiden Figuren sind zudem feine parallele Linien erkennbar, welche Strukturierungslinien für die serielle Verschaltung der Solarzellen entsprechen.

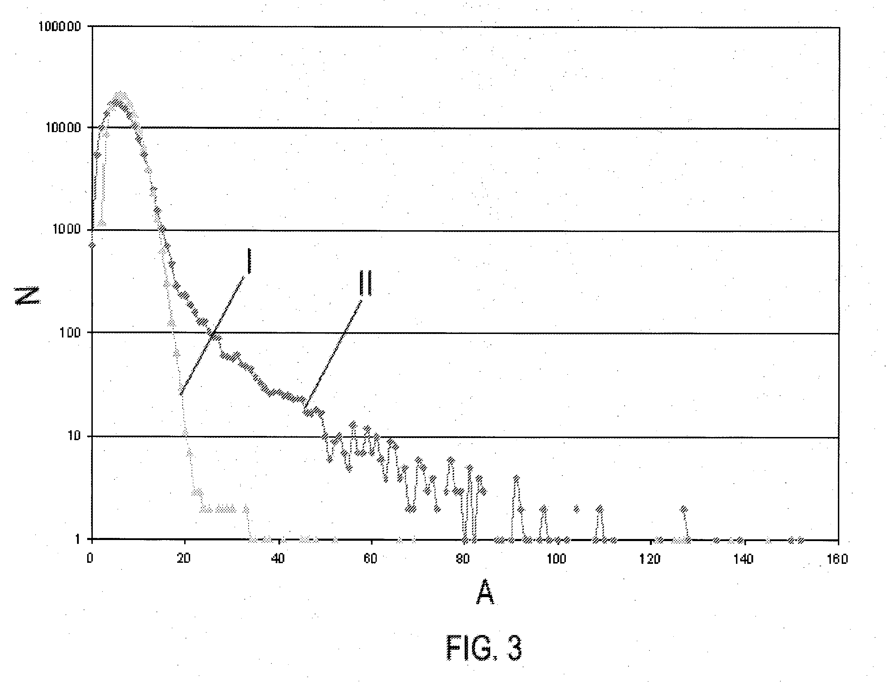

Dann wird aus den Wärmebildern eine auf die jeweilige Anzahl von Bildpunkten mit einem selben Intensitätswert bezogene Intensitätsverteilung (Histogramm) der Wärmestrahlung ermittelt. Eine solche Intensitätsverteilung ist als Diagramm für die beiden Wärmebilder von Fig. 2A und 2B in Fig. 3 gezeigt. In dem Diagramm ist als Abszisse A die Amplitude bzw. Intensität in relativen Einheiten und als Ordinate die Anzahl N von Bildpunkten angegeben. Kurve I entspricht Fig. 2A, Kurve II entspricht Fig. 2B. Ersichtlich weist Kurve II - entsprechend der größeren Defektzahl - in einem mittleren Amplitudenbereich des Diagramms sehr viel mehr Bildpunkte als Kurve I auf.

Anschließend wird aus der Intensitätsverteilung ein Amplituden- bzw. Intensitätsmittelwert und die Standardabweichung unter Anwendung herkömmlicher statistischer Verfahren ermittelt. In der weiteren Auswertung wird eine Kennzahl K ermittelt, indem Produkte summiert werden, die jeweils gegeben sind durch die Anzahl von Bildpunkten mit einem selben Intensitätswert multipliziert mit diesem Intensitätswert. Die Summation erfolgt hier beispielsweise nur für jene Intensitätswerte, die größer sind als der um die Standardabweichung erhöhte Intensitätsmittelwert.

Als Ergebnis wird für die Kurve I ein Wert K_{I} = 157277 und für die Kurve II ein Wert K_{II} = 273340 erhalten. Entsprechend der größeren Defektzahl ist K_{II} wesentlich größer als K_{I}.

Auf Basis dieser Kennzahl K kann nun eine automatisierte Bewertung der Güte des Dünnschichtsolarmoduls 5 erfolgen, wobei die Kennzahl K mit einer bestimmbaren Referenzkennzahl verglichen wird, wobei dem Dünnsichtsolarmodul 5 ein erstes Bewertungsergebnis zugewiesen wird, falls die Kennzahl K größer oder gleich der Referenzkennzahl ist, oder ein vom ersten Bewertungsergebnis verschiedenes, zweites Bewertungsergebnis zugewiesen wird, falls die Kennzahl K kleiner als die Referenzkennzahl ist.

Die Referenzkennzahl hängt von den speziellen Qualitätsanforderungen an das Dünnschichtsolarmoduls 5 ab. Im vorliegenden Ausführungsbeispiel sei die Referenzkennzahl beispielhaft als 200000 festgelegt. Dem Dünnschichtsolarmodul 5 mit dem Wärmebild von Fig. 2A, welches eine Kennzahl K_{I} = 157277 aufweist, wird somit beispielsweise das Bewertungsergebnis "Schichtensystem erfüllt die geforderte Güte" zugewiesen, während dem Dünnschichtsolarmodul 5 mit dem Wärmebild von Fig. 2B, welches eine Kennzahl K_{II} = 273340 aufweist beispielsweise das Bewertungsergebnis "Schichtensystem erfüllt die geforderte Güte nicht" zugewiesen wird und demnach auszusondern ist.

Die vorliegende Erfindung stellt ein automatisiertes Verfahren zur quantitativen Analyse von Solarzellen und Solarmodulen zur Verfügung, das eine einfache und zuverlässige Bewertung deren Güte ermöglicht.

### Bezugszeichenliste

- 1: Aufbau
- 2: Infrarotkamera
- 3: Steuer-/Kontrolleinrichtung
- 4: Träger
- 5: Dünnschichtsolarmodul
- 6: Spannungsquelle
- 7: erste elektrische Leitung
- 8: zweite elektrische Leitung
- 9: Anschluss
- 10: Oberfläche
- 11: erstes Substrat
- 12: Rückelektrodenschicht
- 13: Absorberschicht
- 14: Pufferschicht
- 15: Frontelektrodenschicht
- 16: Klebschicht
- 17: zweites Substrat

## Patentansprüche

1. Verfahren zur bewertenden Analyse eines photovoltaischen Schichtensystems (5), mit den folgenden Schritten:
Erzeugen eines elektrischen Stroms im Schichtensystem (5);
Erzeugen eines ortsaufgelösten Bilds der Wärmestrahlung einer Oberfläche (10) des Schichtensystems (5);
Ermitteln einer auf die jeweilige Anzahl von Bildpunkten mit einem selben Intensitätswert bezogenen Intensitätsverteilung der Wärmestrahlung;
Ermitteln eines Intensitätsmittelwerts/-medians aus der Intensitätsverteilung;
Ermitteln eines auf der Intensitätsverteilung basierenden Intensitätsintervalls durch Anwenden einer vorgebbaren Ermittlungsregel;
Ermitteln einer Kennzahl durch Summieren von Produkten, jeweils gegeben durch die Anzahl von Bildpunkten mit einem selben Intensitätswert multipliziert mit dem Intensitätswert, für alle Intensitätswerte oberhalb des um das Intensitätsintervall erhöhten Intensitätsmittelwerts/-medians;
Vergleichen der Kennzahl oder eines hierauf basierenden Berechnungswerts mit einer vorgebbaren Referenzkennzahl, wobei dem Schichtensystem ein erstes Bewertungsergebnis zugewiesen wird, falls die Kennzahl größer oder gleich der Referenzkennzahl ist, oder ein zweites Bewertungsergebnis zugewiesen wird, falls die Kennzahl kleiner als die Referenzkennzahl ist.

2. Verfahren nach Anspruch 1, **dadurch gekennzeichnet, dass** das photovoltaische Schichtensystem (5) zumindest eine einen pn-Übergang bildende Halbleiterschicht umfasst.

3. Verfahren nach Anspruch 2, **dadurch gekennzeichnet, dass** der elektrische Strom im Schichtensystem (5) durch Anlegen einer elektrischen Spannung in Sperr- und/oder Stromflussrichtung des pn-Übergangs erzeugt wird.

4. Verfahren nach Anspruch 3, **dadurch gekennzeichnet, dass** Spannungen mit unterschiedlicher Polarität und/oder verschiedener Größe angelegt werden.

5. Verfahren nach Anspruch 1 oder 2, **dadurch gekennzeichnet, dass** der elektrische Strom im Schichtensystem (5) durch Bestrahlen des Schichtensystems (5) mit Licht erzeugt wird.

6. Verfahren nach einem der Ansprüche 1 bis 5, **dadurch gekennzeichnet, dass** das Intensitätsintervall auf Basis einer Standardabweichung des Mittelwerts/Medians der Intensitätsverteilung berechnet wird.

7. Verfahren nach einem der Ansprüche 1 bis 6, **dadurch gekennzeichnet, dass** die Kennzahl normiert wird, indem sie durch eine Gesamt-Kennzahl geteilt wird, die sich ergibt aus der Summation von Produkten, jeweils gegeben durch die Anzahl von Bildpunkten mit einem selben Intensitätswert multipliziert mit dem Intensitätswert, für alle Intensitäten der Intensitätsverteilung.

8. Verfahren nach Anspruch 7, **dadurch gekennzeichnet, dass** als Berechnungswert zum Vergleich mit der Referenz-Kennzahl ein Quotient zwischen der Kennzahl und der Gesamt-Kennzahl ermittelt wird.

9. Verfahren nach Anspruch 7, **dadurch gekennzeichnet, dass** als Berechnungswert zum Vergleich mit der Referenz-Kennzahl eine Differenz zwischen der Kennzahl und der Gesamt-Kennzahl ermittelt wird.

10. Verfahren nach einem der Ansprüche 1 bis 9, **dadurch gekennzeichnet, dass** für eine Mehrzahl voneinander verschiedener Abschnitte der Oberfläche des Schichtensystems jeweils eine Kennzahl ermittelt wird.

11. Verfahren nach Anspruch 10, **dadurch gekennzeichnet, dass** die Abschnitte jeweils zumindest eine Strukturierungslinie zur Strukturierung des Schichtensystems enthalten.

12. Verfahren nach Anspruch 10, **dadurch gekennzeichnet, dass** getrennte Abschnitte gebildet werden, wobei die Trennung nach Bereichen mit Strukturierungslinien und Bereichen mit reinen Zellenanteilen erfolgt.

13. Verwendung des Verfahrens nach einem der Ansprüche 1 bis 12 zur bewertenden Analyse von Solarmodulen, insbesondere Dünnschichtsolarmodulen (5), deren Halbleiterschicht aus einer Chalkopyritverbindung, insbesondere Cu(In,Ga)(S,Se)₂, besteht.

## Claims

1. Process for the evaluating analysis of a photovoltaic layer system (5), using the following steps:
generating an electric current in the layer system (5);
generating a spatially resolved image of the heat radiation of a surface (10) of the layer system (5);
determining an intensity distribution of heat radiation relative to the number of pixels with a same intensity value;
determining an intensity average/median from the intensity distribution;
determining an intensity interval based on the intensity distribution by applying a specifiable determination rule;
determining an indicator by the addition of products, each given by the number of pixels with a same intensity value multiplied by the intensity value, for all intensity values above the average/median intensity elevated by the intensity interval;
comparing the indicator or a calculated value based thereon with a specifiable reference indicator, whereby a first evaluation result is assigned to the layer system, should the ratio be greater than or equal to the reference indicator, or a second valuation result is assigned, should the ratio be less than the reference indicator.

2. Process according to claim 1, **characterised in that** the photovoltaic layer system (5) includes at least one semiconductor layer forming a p-n junction.

3. Process according to claim 2, **characterised in that** the electric current in the layer system (5) is produced by applying an electrical voltage in the blocking and or power flow direction of the p-n junction.

4. Process according to claim 3, **characterised in that** voltages with different polarities and/or of different sizes are applied.

5. Process according to claim 1 or 2, **characterised in that** the electric current in the layer system (5) is produced by irradiating the layer system (5) with light.

6. Process according to one of claims 1 to 5, **characterised in that** the intensity interval is calculated on the basis of a standard deviation of the mean/median of the intensity distribution.

7. Process according to one of claims 1 to 6, **characterised in that** the indicator is standardised by being divided by an overall indicator which results from the summation of products, each given by the number of pixels with a same intensity value multiplied by the intensity value for all intensities the intensity distribution.

8. Process according to claim 7, **characterised in that** a quotient is determined between the indicator and the overall indicator as a calculated value for comparing with the reference indicator.

9. Process according to claim 7, **characterised in that** a difference is determined between the indicator and the overall indicator as a calculated value for comparing with the reference indicator.

10. Process according to one of the claims 1 to 9, **characterised in that** for each of a plurality of sections different from each other of the surface of the layer system an indicator is determined.

11. Process according to claim 10, **characterised in that** the sections each contain at least one structuring line for structuring the layer system.

12. Process according to claim 10, **characterised in that** separate sections are formed wherein the separation between areas occurs according to areas with structuring lines and areas with purely a portion of cells.

13. Use of the process according one of the claims 1 to 12 for the evaluative analysis of solar modules, in particular thin-film solar modules (5), whose semiconductor layer consists of a chalkopyrite connection, in particular Cu(In,Ga)(S,Se)₂.

## Revendications

1. Procédé pour l'analyse évaluative d'un système photovoltaïque de couches (5), comprenant les étapes suivantes :
génération d'un courant électrique dans le système de couches (5) ;
génération d'une image en résolution locale du rayonnement thermique d'une surface (10) du système de couches (5) ;
détermination d'une distribution d'intensité du rayonnement thermique par rapport au nombre de pixels d'une même valeur d'intensité ;
détermination d'une intensité moyenne/médiane à partir de la distribution d'intensité ;
détermination d'un intervalle d'intensité basé sur la distribution d'intensité en appliquant une règle de la détermination prédéterminable;
détermination d'un indicateur par l'addition de produits, chacun étant calculé par le nombre de pixels avec une même valeur d'intensité multiplié par la valeur d'intensité, pour toutes les valeurs d'intensité au-dessus de l'intensité moyenne/médiane élevée par l'intervalle d'intensité ;
comparaison de l'indicateur ou d'une valeur calculée basée sur celui-ci avec un indicateur de référence déterminable, où un premier résultat d'évaluation est affecté au système de couches, si le ratio est supérieur ou égal à l'indicateur de référence, ou un deuxième résultat d'évaluation est affectée, si le ratio est inférieure à l'indicateur de référence.

2. Procédé selon la revendication 1, **caractérisé en ce que** le système photovoltaïque de couches (5) comprend au moins une couche semi-conductrice formant une jonction p-n.

3. Procédé selon la revendication 2, **caractérisé en ce que** le courant électrique dans le système de couches (5) est obtenue en appliquant une tension électrique en sens inverse et/ou en sens de circulation de courant de la jonction p-n.

4. Procédé selon la revendication 3, **caractérisé en ce que** des tensions sont appliquées avec des polarités différentes et/ou des tailles différentes.

5. Procédé selon la revendication 1 ou 2, **caractérisé en ce que** le courant électrique dans le système de couches (5) est produit en irradiant le système de couches (5) avec la lumière.

6. Procédé selon l'une des revendications 1 à 5, **caractérisé en ce que** l'intervalle d'intensité est calculé sur la base d'un écart type de la moyenne/médiane de la distribution d'intensité.

7. Procédé selon l'une des revendications 1 à 6, **caractérisé en ce que** l'indicateur est standardisé, dans la mesure où elle est scindée par un indicateur global qui résulte de la sommation de produits, dont chacun est donné par le nombre de pixels avec une même valeur d'intensité multipliée par la valeur d'intensité pour toutes les intensités la distribution d'intensité.

8. Procédé selon la revendication 7, **caractérisé en ce qu'**un quotient est déterminé entre l'indicateur et l'indicateur de référence comme valeur calculée par rapport à l'indicateur de référence.

9. Procédé selon la revendication 7, **caractérisé en ce qu'**une différence est déterminée entre l'indicateur et l'indicateur de référence comme valeur calculée par rapport à l'indicateur de référence.

10. Procédé selon une des revendications 1 à 9, **caractérisé en ce qu'**un indicateur est déterminé pour chacune d'une pluralité de sections, différentes les unes des autres, de la surface du système de couches.

11. Procédé selon la revendication 10, **caractérisé en ce que** les sections contiennent chacune au moins une ligne de structuration pour structurer le système de couches.

12. Procédé selon la revendication 10, **caractérisé en ce que** des sections distinctes sont formées, où la séparation en zones se produit en zones ayant des lignes de structuration et des zones ayant purement des parties de cellules.

13. L'utilisation du procédé selon une des revendications 1 à 12 pour l'analyse évaluative des modules solaires, en particulier les modules solaires à couche mince (5), dont la couche semi-conductrice est constituée d'une connexion de chalcopyrite, en particulier de Cu(In,Ga)(S, Se)₂.
